# EUROPEAN PATENT SPECIFICATION

(11) **EP 1 319 095 B1**
(45) Date of publication and mention of the grant of the patent: **02.11.2006**
(21) Application number: 01973362.5
(22) Date of filing: 21.09.2001
(51) Int. Cl.: D01F 8/04, D01F 1/10

(54) **MULTI-COMPONENT FIBERS HAVING REVERSIBLE THERMAL PROPERTIES**
MEHRKOMPONENTENFASERN MIT REVERSIBLEN THERMISCHEN EIGENSCHAFTEN
FIBRES MULTICOMPOSANTS AUX PROPRIETES THERMIQUES REVERSIBLES

(30) Priority: 21.09.2000 US 234410 P
(43) Date of publication of application: 18.06.2003
(60) Divisional application: 06014812.9
(73) Proprietor: Outlast Technologies, Inc., Boulder, CO 80301 (US)
(72) Inventor: MAGILL, Monte, C., Longmont, CO 80501 (US); HARTMANN, Mark, H., Superior, CO 80027 (US)
(74) Representative: Sutcliffe, Nicholas Robert
(86) International application number: PCT/US2001/029648
(87) International publication number: WO 2002/024992

(56) References cited:
- EP-A- 0 306 202
- WO-A-99/25549
- DATABASE WPI Section Ch, Week 199706 Derwent Publications Ltd., London, GB; Class A17, AN 1997-062307 XP002187982 & JP 08 311716 A (NIPPON ESTER CO LTD), 26 November 1996 (1996-11-26)

## Description

### FIELD OF THE INVENTION

The present invention relates to synthetic fibers having enhanced reversible thermal properties. More particularly, the present invention relates to multi-component fibers comprising phase change materials and to the formation of such fibers via a melt spinning process.

### BACKGROUND OF THE INVENTION

Many fabric materials are made from synthetic fibers. Conventionally, two processes are used to manufacture synthetic fibers: a wet solution process and a melt spinning process. The wet solution process is generally used to form acrylic fibers, while the melt spinning process is generally used to form nylon fibers, polyester fibers, polypropylene fibers, and other similar type fibers. As is well known, a nylon fiber comprises a long-chain synthetic polyamide polymer characterized by the presence of an amide group -CONH-, a polyester fiber comprises a long-chain synthetic polymer having at least 85 percent by weight of an ester of a substituted aromatic carboxylic acid unit, and a polypropylene fiber comprises a long-chain synthetic crystalline polymer having at least 85 percent by weight of an olefin unit and typically having a molecular weight of about 40,000 or more.

The melt spinning process is of particular interest since a large portion of the synthetic fibers that are used in the textile industry are manufactured by this technique. The melt spinning process generally involves passing a melted polymeric material through a device that is known as a spinneret to thereby form a plurality of individual synthetic fibers. Once formed, the synthetic fibers may be collected into a strand or made into a cut staple. Synthetic fibers can be used to make woven or non-woven fabric materials, or alternatively, synthetic fibers can be wound into a yam to be used thereafter in a weaving or a knitting process to form a synthetic fabric material.

Phase change materials have been incorporated into acrylic fibers to provide enhanced reversible thermal properties to the fibers themselves as well as to fabric materials made therefrom. This is readily accomplished, in part due to the high levels of volatile materials (e. g., solvents) typically associated with the wet solution process of forming acrylic fibers. However, it is more problematic to incorporate phase change materials into melt spun synthetic fibers, since high levels of volatile materials typically are not present or desired in the melt spinning process. Previous attempts to incorporate phase change materials into melt spun synthetic fibers typically involved mixing the phase change materials with a standard fiber-grade thermoplastic polymer to form a blend and subsequently melt spinning this blend to form the synthetic fibers. Such attempts generally led to inadequate dispersion of the phase change materials within the fibers, poor fiber properties, and poor processability unless low concentrations of phase change materials were used. However, with low concentrations of the phase change materials, the desired enhanced reversible thermal properties normally associated with use of the phase change materials are difficult to realize.

It is against this background that a need arose to develop multi-component fibers comprising phase change materials.

JP-A-8311716 describes a composite fiber comprising a blend of a thermoplastic polymer with paraffin, covered with a further thermoplastic polymer.

### SUMMARY OF THE INVENTION

The present invention relates to a multi-component fiber according to claim 1.

### BRIEF DESCRIPTION OF THE DRAWINGS

For a better understanding of the nature and objects of the invention, reference should be made to the following detailed description taken in conjunction with the accompanying drawings, in which:
FIG. 1 illustrates enlarged cross sectional views of various exemplary multi-component fibers according to some embodiments of the invention;
FIG. 2 illustrates a three-dimensional view of an exemplary core/sheath fiber according to an embodiment of the invention;
FIG. 3 illustrates a three-dimensional view of another exemplary core/sheath fiber according to an embodiment of the invention; and
FIG. 4 shows a number of properties and manufacturing parameters of six core/sheath fibers that were produced as discussed in Example 1.

### DETAILED DESCRIPTION

The present invention relates to multi-component fibers comprising one or more phase change materials. Multi-component fibers in accordance with various embodiments of the invention have the ability to absorb or release thermal energy to reduce or eliminate heat flow. In addition, such multi-component fibers may exhibit improved processability (e.g., during manufacturing of the fibers or of an article made therefrom), improved strength, improved containment of a phase change material that is dispersed within the fibers, or higher loading levels of the phase change material. The multi-component fibers may be used or incorporated in various articles and applications to provide a thermal regulating property while providing improved strength to the articles and applications. For example, multi-component fibers in accordance with embodiments of the invention may be used in textiles (e.g., fabric materials), apparel (e.g., outdoor clothing, drysuits, and protective suits), footwear (e.g., socks, boots, and insoles), medical products (e.g., thermal blankets, therapeutic pads, incontinent pads, and hot/cold packs), containers and packagings (e.g., beverage/food containers, food warmers, seat cushions, and circuit board laminates), buildings (e.g., insulation in walls or ceilings, wallpaper, curtain linings, pipe wraps, carpets, and tiles), appliances (e.g., insulation in house appliances), and other products (e.g., automotive lining material, sleeping bags, and bedding).

In conjunction with the thermal regulating property provided, multi-component fibers in accordance with various embodiments of the present invention, when incorporated, for example, in apparel or footwear, may provide a reduction in an individual's skin moisture, such as, due to perspiration. For instance, the multi-component fibers may lower the temperature or the relative humidity of the skin, thereby providing a lower degree of skin moisture and a higher level of comfort. The use of specific materials and specific apparel or footwear design features may further enhance this moisture reduction result.

A multi-component fiber according to the invention comprises a plurality of elongated members. According to some embodiments of the invention, the multi-component fiber may comprise a fiber body formed from the plurality of elongated members. The fiber body typically will be elongated and may have a length that is several times (e.g., 100 times or more) greater than its diameter. The fiber body may have a variety of regular or irregular cross sectional shapes such as, by way of example and not by limitation, circular, multi-lobal, octagonal, oval, pentagonal, rectangular, square-shaped, trapezoidal, triangular, wedge-shaped, and so forth. According to some embodiments of the invention, two or more of the elongated members (e.g., two adjacent elongated members) may be joined, combined, united, or bonded to form a unitary fiber body. The elongated members may comprise the same or different polymeric materials, and at least one of the elongated members has a temperature regulating material dispersed therein. The temperature regulating material will comprises a phase change material that provides the multi-component fiber with enhanced reversible thermal properties.

The elongated members may be arranged in a variety of configurations. For instance, the elongated members may be arranged in an island-in-sea configuration, a core-sheath configuration, a matrix or checkerboard configuration, a segmented-pie configuration, a side-by-side configuration, a striped configuration, and so forth. According to some embodiments of the invention, the elongated members may be arranged in a bundle form wherein the elongated members are generally parallel with respect to one another. According to other embodiments of the invention, the elongated members may extend through a substantial portion of a length of the fiber body, and, if desired, they may be longitudinally coextensive.

According to some embodiments of the invention, the multi-component fiber may be between about 0.1 to about 100 denier and typically between about 0.5 to about 10 denier. As one of ordinary skill in the art will understand, a denier is typically understood to be a measure of weight per unit length of a fiber (i.e., grams per 9000 meters).

Depending upon the method of manufacturing the multi-component fiber, desirability of further processing, or particular application of the multi-component fiber, the multi-component fiber may further comprise one or more additional components, such as, for example, water, surfactants, dispersants, anti-foam agents (e.g., silicone containing compounds and flourine containing compounds), antioxidants (e.g., hindered phenols and phosphites), thermal stabilizers (e.g., phosphites, organophosphorous compounds, metal salts of organic carboxylic acids, and phenolic compounds), microwave absorbing additives (e.g., multifunctional primary alcohols, glycerine, and carbon), reinforcing-fibers (e.g., carbon fibers, aramid fibers, and glass fibers), conductive fibers or particles (e.g., graphite or activated carbon fibers or particles), lubricants, process aids (e.g., metal salts of fatty acids, fatty acid esters, fatty acid ethers, fatty acid amides, sulfonamides, polysiloxanes, organophosphorous compounds, and phenolic polyethers), fire retardants (e.g., halogenated compounds, phosphorous compounds, and boron compounds), and so forth. The one or more additional components may be dispersed within one or more of the elongated members comprising the multi-component fiber. In addition, certain treatments or coatings may be applied to the multi-component fiber to impart additional properties such as, by way of example and not by limitation, stain resistance, water repellency, softer feel, and moisture management properties. Exemplary treatments and coatings include Epic by Nextec Applications Inc., Intera by Intera Technologies, Inc., Zonyl Fabric Protectors by DuPont Inc., Scotchgard by 3M Co., and so forth.

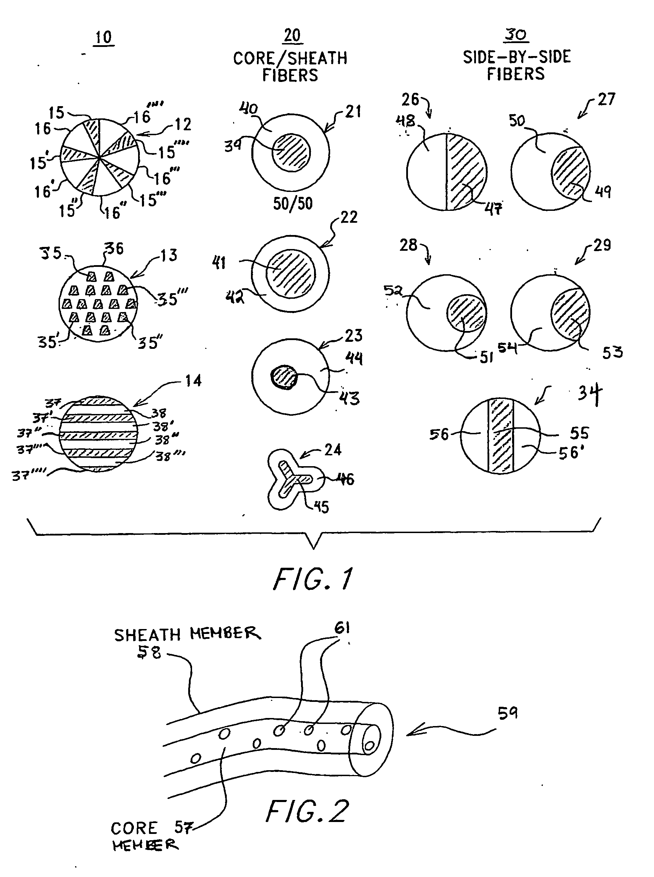

The invention can be more fully appreciated with reference to FIG. 1, which provides, by way of example and not by limitation, enlarged cross-sectional views of various exemplary multi-component fibers 12, 13, 14, 21, 22, 23, 24, 26, 27, 28, 29, and 34 according to some embodiments of the invention. More particularly, FIG. 1 illustrates a variety of exemplary configurations of arranging elongated members comprising the multi-component fibers, according to some embodiments of the invention.

As shown in FIG. 1, each multi-component fiber (e.g., 21) comprises a plurality of distinct cross sectional domains corresponding to a plurality of elongated members (e.g., 39 and 40) that form the multi-component fiber. According to the presently illustrated embodiments, the elongated members include a first elongated member (or a first plurality of elongated members) (shown shaded in FIG. 1) and a second elongated member (or a second plurality of elongated members) (shown unshaded in FIG. 1). Here, the first elongated member (or the first plurality of elongated members) is formed from a polymeric material that has a temperature regulating material dispersed therein. The second elongated member (or the second plurality of elongated members) may be formed from the same polymeric material or another polymeric material having somewhat different properties.

While FIG. 1 illustrates multi-component fibers with circular or tri-lobal cross sectional shapes, multi-component fibers with a variety of other regular or irregular cross sectional shapes are encompassed by the invention, such as, by way of example and not by limitation, multi-lobal, octagonal, oval, pentagonal, rectangular, square-shaped, trapezoidal, triangular, wedge-shaped, and so forth. It should be recognized that, in general, a first plurality of elongated members may be formed from the same or different polymeric materials, and a second plurality of elongated members may be formed from the same or different polymeric materials. Moreover, a temperature regulating material may be dispersed within a second elongated member (or a second plurality of elongated members), according to some embodiments of the invention. It should be further recognized that two or more different temperature regulating materials may be dispersed within the same or different elongated members. For instance, a first temperature regulating material may be dispersed within a first elongated member, and a second temperature regulating material having somewhat different properties may be dispersed within a second elongated member (e.g., two different phase change materials). Additionally, it should be recognized that the number, shapes, and sizes of the elongated members shown in FIG. 1 are illustrated by way of example and not by limitation, and various other embodiments are within the scope of the invention.

With reference to FIG. 1, left-hand column 10 illustrates three exemplary multi-component fibers 12, 13, and 14. Multi-component fiber 12 comprises a plurality of elongated members arranged in a segmented-pie configuration. In the present embodiment, a first plurality of elongated members 15, 15', 15", 15"', and 15"" and a second plurality of elongated members 16, 16', 16", 16"', and 16"" are arranged in an alternating fashion and have cross sectional areas that are wedge-shaped. In general, the elongated members may have the same or different cross sectional shapes or sizes. Moreover, while multi-component fiber 12 is shown comprising ten elongated members, it should be recognized that, in general, two or more elongated members may be arranged in a segmented-pie configuration, and at least one of the elongated members typically has a temperature regulating material dispersed therein.

Multi-component fiber 13 comprises a plurality of elongated members arranged in an island-in-sea configuration. In the present embodiment, a first plurality of elongated members 35, 35' 35", 35"', etc. are positioned within and surrounded by a second elongated member 36. In the present embodiment, each of the first plurality of elongated members has a cross sectional shape that is trapezoidal. It should be recognized, however, that a variety of other regular or irregular cross sectional shapes are encompassed by the invention, such as, by way of example and not by limitation, circular, multi-lobal, octagonal, oval, pentagonal, rectangular, square-shaped, triangular, wedge-shaped, and so forth. In general, the first plurality of elongated members 35, 35', 35'', 35''', etc. may have the same or different cross sectional shapes or sizes. Moreover, while multi-component fiber 13 is shown with seventeen elongated members 35, 35', 35'', 35''', etc. positioned within and surrounded by the second elongated member 36, it should be recognized that, in general, one or more elongated members may be positioned within and surrounded by the second elongated member 36.

Multi-component fiber 14 comprises a plurality of elongated members arranged in a striped configuration. In the present embodiment, a first plurality of elongated members 37, 37', 37", 37"', and 37"" and a second plurality of elongated members 38, 38', 38", and 38"' are arranged in an alternating fashion and are shaped as longitudinal slices of the multi-component fiber 14. In general, the elongated members may have the same or different cross sectional shapes or sizes (e.g., widths associated with the longitudinal slices). Moreover, while multi-component fiber 14 is shown comprising nine elongated members, it should be recognized that, in general, two or more elongated members may be arranged in a striped configuration, and at least one of the elongated members typically has a temperature regulating material dispersed therein.

In the case of multi-component fibers 12 and 14, a first elongated member (e.g., 15) is shown partially surrounded by an adjacent second elongated member or members (e.g., 16 and 16""), whereas, in the case of multi-component fiber 13, a first elongated member (e.g., 35) is shown completely surrounded by a unitary second elongated member 36. When a first elongated member (e.g., 15) is not completely surrounded, it may be desirable, but not required, that a containment structure (e.g., microcapsules) be used to contain a phase change material dispersed within the first elongated member.

Middle column 20 of FIG. 1 illustrates four exemplary core/sheath fibers 21, 22, 23, and 24. In particular, core/sheath fibers 21, 22, 23, and 24 each comprises a plurality of elongated members arranged in a core-sheath configuration.

Core/sheath fiber 21 comprises a first elongated member 39 positioned within and surrounded by a second elongated member 40. More particularly, the first elongated member 39 is formed as a core member having a temperature regulating material dispersed therein. This core member is shown concentrically positioned within and completely surrounded by the second elongated member 40 that is formed as a sheath member. Here, core/sheath fiber 21 comprises 25 percent by weight of the core member and 75 percent by weight of the sheath member.

Core/sheath fiber 22 comprises a first elongated member 41 positioned within and surrounded by a second elongated member 42. As with the previously discussed embodiment, the first elongated member 41 is formed as a core member having a temperature regulating material dispersed therein and is concentrically positioned within and completely surrounded by the second elongated member 42 that is formed as a sheath member. Here, core/sheath fiber 22 comprises 50 percent by weight of the core member and 50 percent by weight of the sheath member.

Core/sheath fiber 23 comprises a first elongated member 43 positioned within and surrounded by a second elongated member 44. In the present embodiment, however, the first elongated member 43 is formed as a core member that is eccentrically positioned within the second elongated member 44 that is formed as a sheath member. Core/sheath fiber 23 may comprise virtually any percentages by weight of the core member and the sheath member to provide desired thermal regulating and mechanical properties.

Tri-lobal core/sheath fiber 24 comprises a first elongated member 45 positioned within and surrounded by a second elongated member 46. In the present embodiment, the first elongated member 45 is formed as a core member that has a tri-lobal cross sectional shape. This core member is concentrically positioned within the second elongated member 46 that is formed as a sheath member. Core/sheath fiber 23 may comprise virtually any percentages by weight of the core member and the sheath member to provide desired thermal regulating and mechanical properties.

It should be recognized that a core member may, in general, have a variety of regular or irregular cross sectional shapes, such as, by way of example and not by limitation, circular, multi-lobal, octagonal, oval, pentagonal, rectangular, square-shaped, trapezoidal, triangular, wedge-shaped, and so forth. While core/sheath fibers 21, 22, 23, and 24 are shown with one core member positioned within and surrounded by a sheath member, it should be recognized that two or more core members may be positioned within and surrounded by a sheath member (e.g., in a manner similar to that shown for multi-component fiber 13). These two or more core members may have the same or different cross sectional shapes or sizes. According to some embodiments of the invention, a core/sheath fiber comprises three or more elongated members arranged in a core-sheath configuration, wherein the elongated members are shaped as concentric or eccentric longitudinal slices of the core/sheath fiber.

Right-hand column 30 of FIG. 1 illustrates a number of exemplary side-by-side fibers in accordance with some embodiments of the invention. In particular, side-by-side fibers 26, 27, 28, 29, and 34 each comprises a plurality of elongated members arranged in a side-by-side configuration.

Side-by-side fiber 26 comprises a first elongated member 47 positioned adjacent and partially surrounded by a second elongated member 48. In the present embodiment, the elongated members 47 and 48 have half-circular cross sectional shapes. Here, side-by-side fiber 26 comprises 50 percent by weight of the first elongated member 47 and 50 percent by weight of the second elongated member 48. It should be recognized that the elongated members 47 and 48 may, alternatively or in conjunction, be characterized as being arranged in a segmented-pie or a striped configuration.

Side-by-side fiber 27 comprises a first elongated member 49 positioned adjacent and partially surrounded by a second elongated member 50. In the present embodiment, side-by-side fiber 27 comprises 20 percent by weight of the first elongated member 49 and 80 percent by weight of the second elongated member 50. It should be recognized that the elongated members 49 and 50 may, alternatively or in conjunction, be characterized as being arranged in a core-sheath configuration, wherein the first elongated member 49 is eccentrically positioned with respect to and partially surrounded by the second elongated member 50.

Side-by-side fibers 28 and 29 are two exemplary mixed-viscosity fibers. Each fiber comprises a first elongated member 51 or 53 having a temperature regulating material dispersed therein that is positioned adjacent and partially surrounded by a second elongated member 52 or 54. A mixed viscosity-fiber is typically considered to be a self-crimping or self-texturing fiber, wherein the fiber's crimping or texturing imparts loft, bulk, insulation, stretch, or other like properties to the fiber. Typically, a mixed-viscosity fiber comprises a plurality of elongated members that are formed from different polymeric materials. For example, for side-by-side fiber 28, the first elongated member 51 may be formed from a first polymeric material, and the second elongated member 52 may be formed from a second polymeric material that may differ in some fashion from the first polymeric material. In the present embodiment, the first and second polymeric materials may comprise polymers with different viscosities or molecular weights (e.g., two polypropylenes with different molecular weights). When side-by-side fiber 28 is drawn, uneven stresses may be created between the two elongated members 51 and 52, and side-by-side fiber 28 may crimp or bend. According to other embodiments of the invention, the first and second polymeric materials may comprise polymers having different degrees of crystallinity. For instance, the first polymeric material may have a lower degree of crystallinity than the second polymeric material. When side-by-side fiber 28 is drawn, the first and second polymeric materials may undergo different degrees of crystallization and orientation to "lock" an orientation and strength into the fiber 28. A sufficient degree of crystallization may be desired to prevent or reduce reorientation of the fiber 28 during heat treatment. Side-by-side fibers 28 and 29 may comprise virtually any percentages by weight of the first and second elongated members to provide desired thermal regulating, mechanical, and self-crimping or self-texturing properties.

Side-by-side fiber 34 is an exemplary ABA fiber comprising a first elongated member 55 positioned between and partially surrounded by a second plurality of elongated members 56 and 56'. In the present embodiment, the first elongated member 55 is formed from a first polymeric material that has a temperature regulating material dispersed therein. Here, the second plurality of elongated members 56 and 56' may be formed from the first polymeric material or from a second polymeric material that may differ in some fashion from the first polymeric material. In general, the elongated members 56 and 56' may have the same or different cross sectional shapes or sizes (e.g., widths associated with the longitudinal slices). It should be recognized that the elongated members 55, 56, and 56' may, alternatively or in conjunction, be characterized as being arranged in a striped configuration.

Turning next to FIG. 2, a three-dimensional view of an exemplary core/sheath fiber 59 is illustrated. Core/sheath fiber 59 comprises an elongated and generally cylindrical core member 57 positioned within and surrounded by an elongated and annular-shaped sheath member 58. The core member 57 has a temperature regulating material 61 dispersed therein and is positioned within and completely surrounded or encased by the sheath member 58. In the present embodiment, the temperature regulating material 61 comprises a plurality of microcapsules containing a phase change material, and the microcapsules may be uniformly dispersed throughout the core member 57. Those of ordinary skill in the art will appreciate that, while it may be preferred to have the microcapsules evenly dispersed within the core member 57, this is not necessary in all applications. The core member 57 may be concentrically or eccentrically positioned within the sheath member 58, and core/sheath fiber 59 may comprise virtually any percentages by weight of the core member 57 and the sheath member 58 to provide desired thermal regulating and mechanical properties.

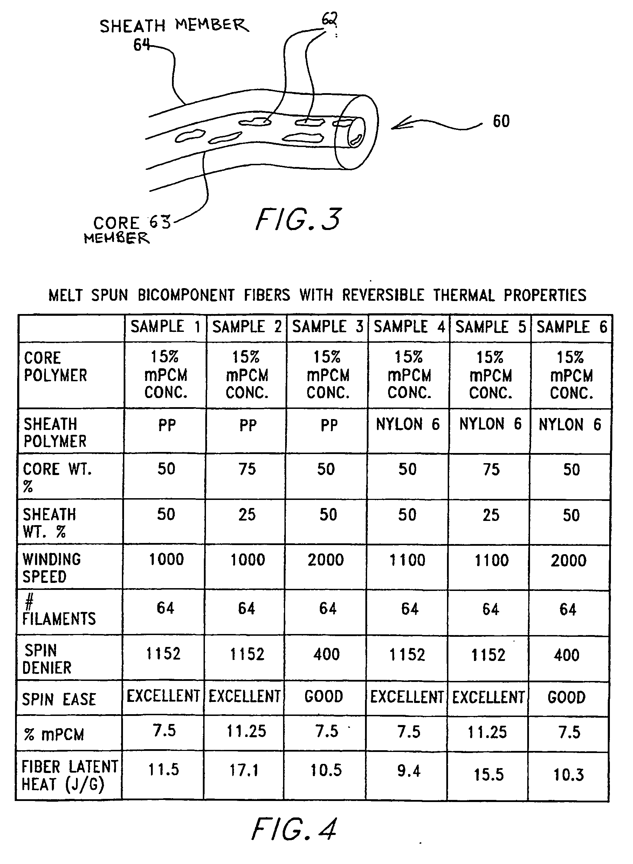

With reference to FIG. 3, a three-dimensional view of another exemplary core/sheath fiber 60 is illustrated. As with core/sheath fiber 59, core/sheath fiber 60 comprises an elongated and generally cylindrical core member 63 positioned within and completely surrounded or encased by an elongated and annular-shaped sheath member 64. Here, a temperature regulating material 62 comprises a phase change material in a raw form (e.g., the phase change material is non-encapsulated, i.e., not micro- or macroencapsulated), and the phase change material may be uniformly dispersed throughout the core member 63. Those of ordinary skill in the art will appreciate that, while it may be preferred to have the phase change material evenly dispersed within the core member 63, this is not necessary in all applications. By surrounding the core member 63, the sheath member 64 may serve to enclose the phase change material within the core member 63. Accordingly, the sheath member 64 may reduce or prevent loss or leakage of the phase change material during fiber processing or during end use. The core member 63 may be concentrically or eccentrically positioned within the sheath member 64, and core/sheath fiber 60 may comprise virtually any percentages by weight of the core member 63 and the sheath member 64 to provide desired thermal regulating and mechanical properties.

As discussed above, a multi-component fiber according to the invention comprises a temperature regulating material that is dispersed within one or more elongated members. Typically, the temperature regulating material will be uniformly dispersed within at least one of the elongated members. However, depending upon the particular characteristics desired from the multi-component fiber, the dispersion of temperature regulating material may be varied within one or more of the elongated members. The temperature regulating material typically will comprise one or more phase change materials.

In general, a phase change material may comprise any substance (or mixture of substances) that has the capability of absorbing or releasing thermal energy to reduce or eliminate heat flow at or within a temperature stabilizing range. The temperature stabilizing range may comprise a particular transition temperature or range of transition temperatures. A phase change material used in conjunction with various embodiments of the invention preferably will be capable of inhibiting a flow of thermal energy during a time when the phase change material is absorbing or releasing heat, typically as the phase change material undergoes a transition between two states (e.g., liquid and solid states, liquid and gaseous states, solid and gaseous states, or two solid states). This action is typically transient, e.g., will occur until a latent heat of the phase change material is absorbed or released during a heating or cooling process. Thermal energy may be stored or removed from the phase change material, and the phase change material typically can be effectively recharged by a source of heat or cold. By selecting an appropriate phase change material, the multi-component fiber may be designed for use in any one of numerous products or applications.

According to some embodiments of the invention, a phase change material may be a solid/solid phase change material. A solid/solid phase change material is a type of phase change material that typically undergoes a transition between two solid states (e.g., a crystalline or mesocrystalline phase transformation) and hence typically does not become a liquid during use.

Phase change materials that can be incorporated in multi-component fibers in accordance with various embodiments of the invention include a variety of organic and inorganic substances. Exemplary phase change materials include, by way of example and not limitation, hydrocarbons (e.g., straight chain alkanes or paraffinic hydrocarbons, branched-chain alkanes, unsaturated hydrocarbons, halogenated hydrocarbons, and alicyclic hydrocarbons), hydrated salts (e.g., calcium chloride hexahydrate, calcium bromide hexahydrate, magnesium nitrate hexahydrate, lithium nitrate trihydrate, potassium fluoride tetrahydrate, ammonium alum, magnesium chloride hexahydrate, sodium carbonate decahydrate, disodium phosphate dodecahydrate, sodium sulfate decahydrate, and sodium acetate trihydrate), waxes, oils, water, fatty acids, fatty acid esters, dibasic acids, dibasic esters, 1-halides, primary alcohols, aromatic compounds, clathrates, semi-clathrates, gas clathrates, anhydrides (e.g., stearic anhydride), ethylene carbonate, polyhydric alcohols (e.g., 2,2-dimethyl-1,3-propanediol, 2-hydroxymethyl-2-methyl-1,3-propanediol, ethylene glycol, polyethylene glycol, pentaerythritol, dipentaerythrital, pentaglycerine, tetramethylol ethane, neopentyl glycol, tetramethylol propane, monoaminopentaerythritol, diaminopentaerythritol, and tris(hydroxvmethyl)acetic acid), polymers (e.g., polyethylene, polyethylene glycol, polypropylene, polypropylene glycol, polytetramethylene glycol, and copolymers, such as polyacrylate or poly(meth)acrylate with alkyl hydrocarbon side chain or with polyethylene glycol side chain and copolymers comprising polyethylene, polyethylene glycol, polypropylene, polypropylene glycol, or polytetramethylene glycol), metals, and mixtures thereof.

Table 1 provides a list of exemplary paraffinic hydrocarbons that may be used as a phase change material in the multi-component fibers described herein.

**Table 1**

| Paraffinic Hydrocarbon | No. of | Melting |
|---|---|---|
| | Carbon | Point °C |
| | Atoms | |
| n-Octacosane | 28 | 61.4 |
| n-Heptacosane | 27 | 59.0 |
| n-Hexacosane | 26 | 56.4 |
| n-Pentacosane | 25 | 53.7 |
| n-Tetracosane | 24 | 50.9 |
| n-Tricosane | 23 | 47.6 |
| n-Docosane | 22 | 44.4 |
| n-Heneicosane | 21 | 40.5 |
| n-Eicosane | 20 | 36.8 |
| n-Nonadecane | 19 | 32.1 |
| n-Octadecane | 18 | 28.2 |
| n-Heptadecane | 17 | 22.0 |
| n-Hexadecane | 16 | 18.2 |
| n-Pentadecane | 15 | 10.0 |
| n-Tetradecane | 14 | 5.9 |
| n-Tridecane | 13 | -5.5 |

A phase change material can comprise a mixture of two or more substances (e.g., two or more of the exemplary phase change materials discussed above). By selecting two or more different substances (e.g., two different paraffinic hydrocarbons) and forming a mixture thereof, a temperature stabilizing range can be adjusted over a wide range for any particular application of the multi-component fiber. According to some embodiments of the invention, a phase change material may comprise a copolymer of two or more substances (e.g., two or more of the exemplary phase change materials discussed above).

According to some embodiments of the invention, the temperature regulating material may comprise a phase change material in a raw form (e.g., the phase change material is non-encapsulated, i.e., not micro- or macroencapsulated). During manufacture of the multi-component fiber, the phase change material in the raw form may be provided as a solid in a variety of forms (e.g., bulk form, powders, pellets, granules, flakes, and so forth) or as a liquid in a variety of forms (e.g., molten form, dissolved in a solvent, and so forth).

According to other embodiments of the invention, the temperature regulating material may further comprise a containment structure that encapsulates, contains, surrounds, or absorbs a phase change material. This containment structure may facilitate handling of the phase change material while offering a degree of protection to the phase change material during manufacture of the multi-component fiber or an article made therefrom (e.g., protection from high temperatures or shear forces). Moreover, the containment structure may serve to prevent leakage of the phase change material from the multi-component fiber during use.

For instance, the temperature regulating material may comprise a plurality of microcapsules that contain a phase change material, and the microcapsules may be uniformly, or non-uniformly, dispersed within at least one of the elongated members. The microcapsules may be formed as hollow shells enclosing the phase change material and may comprise individual microcapsules formed in a variety regular or irregular shapes (e.g., spherical, ellipsoidal, and so forth) and sizes. The individual microcapsules may have the same or different shapes or sizes. According to some embodiments of the invention, the microcapsules may have a maximum linear dimension (e.g., diameter) ranging from about 0.01 to about 100 microns. In one presently preferred embodiment, the microcapsules will have a generally spherical shape and will have a maximum linear dimension (e.g., diameter) ranging from about 0.5 to about 3 microns. Other examples of the containment structure may include, by way of example and not by limitation, silica particles (e.g., precipitated silica particles, fumed silica particles, and mixtures thereof), zeolite particles, carbon particles (e.g., graphite particles, activated carbon particles, and mixtures thereof), and absorbent materials (e.g., absorbent polymeric materials, superabsorbent materials, cellulosic materials, poly(meth)acrylate materials, metal salts of poly(meth)acrylate materials, and mixtures thereof). For instance, the temperature regulating material may comprise silica particles, zeolite particles, carbon particles, or an absorbent material impregnated with a phase change material.

According to some embodiments of the invention, one or more elongated members may each comprise from about 5 percent to about 70 percent by weight of the temperature regulating material. Thus, in one embodiment, an elongated member may comprise 60 percent by weight of the temperature regulating material, and in other embodiments, the elongated member may comprise from about 10 percent to about 30 percent or from about 15 percent to about 25 percent by weight of the temperature regulating material.

As discussed previously, a multi-component fiber according to the invention comprises a plurality of elongated members that are formed from the same or different polymeric materials. According to the invention, the elongated members include a first elongated member (or a first plurality of elongated members) formed from a first polymeric material that has a temperature regulating material dispersed therein. In addition, the elongated members include a second elongated member (or a second plurality of elongated members) formed from a second polymeric material that may differ in some fashion from the first polymeric material. According to some embodiments of the invention, the elongated members may be formed from the same polymeric material, in which case the first and second polymeric materials will be the same.

In general, a polymeric material (e.g., the first polymeric material or the second polymeric material) may comprise any polymer (or mixture of polymers) that has the capability of being formed into an elongated member. According to some embodiments of the invention, an elongated member may be formed from any fiber-forming polymer (or mixture of fiber-forming polymers). According to embodiments of the invention wherein a melt spinning process is used to form the multi-component fiber, a polymeric material may comprise a thermoplastic polymer (or mixture of thermoplastic polymers) (i.e., one that can be heated to form a melt and subsequently shaped or molded to form an elongated member).

A polymeric material may comprise a polymer (or mixture of polymers) having a variety of chain structures that include one or more types of monomer units. In particular, a polymeric material may comprise a linear polymer, a branched polymer (e.g., star branched polymer, comb branched polymer, or dendritic branched polymer), or a mixture thereof. A polymeric material may comprise a homopolymer, a copolymer (e.g., statistical copolymer, random copolymer, alternating copolymer, periodic copolymer, block copolymer, radial copolymer, or graft copolymer), or a mixture thereof. As one of ordinary skill in the art will understand, the reactivity and functionality of a polymer may be altered by addition of a group such as, for example, amine, amide, carboxyl, hydroxyl, ester, ether, epoxide, anhydride, isocyanate, silane, ketone, and aldehyde. Also, a polymer comprising a polymeric material may be capable of crosslinking, entanglement, or hydrogen bonding in order to increase its toughness or its resistance to heat, moisture, or chemicals.

Exemplary polymers that may be used to form an elongated member according to various embodiments of the invention include, by way of example and not by limitation, polyamides (e.g., Nylon 6, Nylon 6/6, Nylon 12, polyaspartic acid, polyglutamic acid, and so forth), polyamines, polyimides, polyacrylics (e.g., polyacrylamide, polyacrylonitrile, esters of methacrylic acid and acrylic acid, and so forth), polycarbonates (e.g., polybisphenol A carbonate, polypropylene carbonate, and so forth), polydienes (e.g., polybutadiene, polyisoprene, polynorbornene, and so forth), polyepoxides, polyesters (e.g., polyethylene terephthalate, polybutylene terephthalate, polytrimethylene terephthalate, polycaprolactone, polyglycolide, polylactide, polyhydroxybutyrate, polyhydroxyvalerate, polyethylene adipate, polybutylene adipate, polypropylene succinate, and so forth), polyethers (e.g., polyethylene glycol (polyethylene oxide), polybutylene glycol, polypropylene oxide, polyoxymethylene (paraformaldehyde), polytetramethylene ether (polytetrahydrofuran), polyepichlorohydrin, and so forth), polyflourocarbons, formaldehyde polymers (e.g., urea-formaldehyde, melamine-formaldehyde, phenol formaldehyde, and so forth), natural polymers (e.g., cellulosics, chitosans, lignins, waxes, and so forth), polyolefins (e.g., polyethylene, polypropylene, polybutylene, polybutene, polyoctene, and so forth), polyphenylenes (e.g., polyphenylene oxide, polyphenylene sulfide, polyphenylene ether sulfone, and so forth), silicon containing polymers (e.g., polydimethyl siloxane, polycarbomethyl silane, and so forth), polyurethanes, polyvinyls (e.g., polyvinyl butryal, polyvinyl alcohol, polyvinyl acetate, polystyrene, polymethylstyrene, polyvinyl chloride, polyvinyl pryrrolidone, polymethyl vinyl ether, polyethyl vinyl ether, polyvinyl methyl ketone, and so forth), polyacetals, polyarylates, and copolymers (e.g., polyethylene-co-vinyl acetate, polyethylene-co-acrylic acid, polybutylene terphthalate-co-polytetramethylene terephthalate, polylauryllactam-block-polytetrahydrofuran, and so forth).

According to some embodiments of the invention, the first polymeric material may comprise a polymer (or mixture of polymers) that facilitates dispersing or incorporating the temperature regulating material within the first elongated member (or the first plurality of elongated members). According to some embodiments of the invention, the first polymeric material may comprise a polymer (or mixture of polymers) that is compatible with or has an affinity for the temperature regulating material. Such affinity may facilitate dispersion of the temperature regulating material in an intermediate molten or liquid form of the first polymeric material during manufacture of the multi-component fiber and, thus, ultimately may facilitate incorporation of more uniform or greater amounts or loading level of a phase change material in the multi-component fiber. In embodiments where the temperature regulating material further comprises a containment structure, the first polymeric material may comprise a polymer (or mixture of polymers) selected for its affinity for the containment structure in conjunction with or as an alternative to its affinity for the phase change material. For instance, if the temperature regulating material comprises a plurality of microcapsules containing the phase change material, a polymer (or mixture of polymers) may be selected having an affinity for the microcapsules (e.g., for a material or materials of which the microcapsules are formed). For instance, some embodiments of the invention may select the first polymeric material to comprise the same or a similar polymer as a polymer comprising the microcapsules (e.g., if the microcapsules comprise nylon shells, the first polymeric material may be selected to comprise nylon). Such affinity may facilitate dispersion of the microcapsules containing the phase change material in an intermediate molten or liquid form of the first polymeric material and, thus, ultimately facilitates incorporation of more uniform or greater amounts or loading level of the phase change material in the multi-component fiber.

According to some embodiments of the invention, the first polymeric material may comprise a polymer (or mixture of polymers) that has a slight or partial compatibility with or affinity for the temperature regulating material. Such partial affinity may be adequate to facilitate dispersion of the temperature regulating material and to facilitate processing at higher temperatures and during a melt spinning process. At lower temperatures and shear conditions and once the multi-component fiber has been formed, this partial affinity may allow the temperature regulating material to separate out. For embodiments of the invention wherein a phase change material in a raw form is used, this partial affinity may lead to insolubilization of the phase change material and increased phase change material domain formation within the multi-component fiber. According to some embodiments of the invention, domain formation may lead to an improved thermal regulating property by facilitating transition of the phase change material between two states. For example, certain phase change materials such as paraffinic hydrocarbons may be compatible with polymeric materials comprising polyethylene or polyethylene-co-vinyl acetate at lower concentrations of the phase change materials or when the temperature is above a critical solution temperature. Mixing of a paraffinic hydrocarbon and polyethylene or polyethylene-co-vinyl acetate may be achieved at higher temperatures and higher concentrations of the paraffinic hydrocarbon to produce a homogenous blend that may be easily controlled, pumped, and processed in a melt spinning process. Once a multi-component fiber has been formed and has cooled, the paraffinic hydrocarbon may become insoluble and may separate out into distinct domains. These domains may allow for pure melting or crystallization of the paraffinic hydrocarbon for an improved thermal regulating property.

According to an embodiment of the invention, the first polymeric material may comprise a low molecular weight polymer (or a mixture of low molecular weight polymers). A low molecular weight polymer typically has a low viscosity when heated to form a melt, which low viscosity may facilitate dispersion of the temperature regulating material in the melt. As one of ordinary skill in the art will understand, some polymers may be provided in a variety of forms having different molecular weights, since the molecular weight of a polymer may be determined by conditions used for manufacturing the polymer. Accordingly, as used herein, the term "low molecular weight polymer" may refer to a low molecular weight form of a polymer (e.g., a low molecular weight form of an exemplary polymer discussed previously), and the term "molecular weight" may refer to a number average molecular weight, weight average molecular weight, or melt index of the polymer. For instance, a polyethylene having a number average molecular weight of about 20,000 (or less) may be used as the low molecular weight polymer in an embodiment of the invention. It should be recognized that a molecular weight or range of molecular weights associated with a low molecular weight polymer may depend on the particular polymer selected (e.g., polyethylene) or on the method or equipment used to disperse the temperature regulating material in a melt of the low molecular weight polymer.

According to another embodiment of the invention, the first polymeric material may comprise a mixture of a low molecular weight polymer and a high molecular weight polymer. A high molecular weight polymer typically has enhanced physical properties (e.g., mechanical properties) but may have a high viscosity when heated to form a melt. As used herein, the term "high molecular weight polymer" may refer to a high molecular weight form of a polymer (e.g., a high molecular weight form of an exemplary polymer discussed previously). A low molecular weight polymer or a high molecular weight polymer may be selected to be compatible with or to have an affinity for one another. Such affinity may facilitate forming a mixture of the low molecular weight polymer, the high molecular weight polymer, and the temperature regulating material during manufacture of the multi-component fiber and, thus, ultimately facilitates incorporation of more uniform or greater amounts or loading level of the phase change material in the multi-component fiber. According to some embodiments of the invention, the low molecular weight polymer serves as a compatibilizing link between the high molecular weight polymer and the temperature regulating material to thereby facilitate incorporating the temperature regulating material in the multi-component fiber.

According to some embodiments of the invention, an elongated member may typically comprise from about 10 percent to about 30 percent by weight of the temperature regulating material with the remaining portion of the elongated member comprising a low molecular weight polymer and a high molecular weight polymer. For example, in one presently preferred embodiment, the elongated member may comprise 15 percent by weight of the low molecular weight polymer, 70 percent by weight of the high molecular weight polymer, and 15 percent by weight of the temperature regulating material.

According to some embodiments of the invention, the second polymeric material may comprise a polymer (or mixture of polymers) that has or provides one or more desired physical properties for the multi-component fiber. Exemplary desired physical properties include, by way of example and not by limitation, mechanical properties (e.g., ductility, tensile strength, and hardness), thermal properties (e.g., thermoformability), and chemical properties (e.g., reactivity). The second polymeric material may comprise a polymer (or mixture of polymers) selected to compensate for any deficiencies (e.g., mechanical or thermal deficiencies) of the first polymeric material or of the first elongated member (or the first plurality of elongated members), such as due to a high loading level of the temperature regulating material. According to some embodiments of the invention, the second polymeric material operates to improve the multi-component fiber's overall physical properties (e.g., mechanical properties) and the multi-component fiber's processability (e.g., by facilitating its formation via a melt spinning process). The second polymeric material may serve to enclose the temperature regulating material that is dispersed within the first elongated member (or the first plurality of elongated members). Accordingly, the second polymeric material may allow for the use of a first polymeric material or of a temperature regulating material that is not optimized for high temperature and high shear fiber processing. In addition, the second polymeric material may reduce or prevent loss or leakage of a phase change material during fiber processing or during end use.

According to an embodiment of the invention, the second polymeric material may comprise a high molecular weight polymer. As discussed previously, a high molecular weight polymer typically has enhanced physical properties (e.g., mechanical properties) and may be selected to be a high molecular weight form of a polymer (e.g., a high molecular weight form of an exemplary polymer discussed previously).

According to some presently preferred embodiments of the invention, the second polymeric material may comprise a polyester due, in part, to its excellent processability, properties imparted to a resulting fiber, and its resistance to certain phase change materials such as paraffinic hydrocarbons to reduce or prevent loss or leakage of these phase change materials. According to an embodiment of the invention, the polyester may have a number average molecular weight of about 20,000 (or more).

At this point, those of ordinary skill in the art can appreciate a number of advantages associated with various embodiments of the invention. For instance, a multi-component fiber in accordance with various embodiments of the invention can comprise high loading levels of one or more phase change materials dispersed within a first elongated member (or a first plurality of elongated members). According to some embodiments of the invention, a high loading level can be provided because a second elongated member (or a second plurality of elongated members) surrounds the first elongated member (or the first plurality of elongated members). The second elongated member may comprise a polymer (or mixture of polymers) selected to compensate for any deficiencies (e.g., mechanical or thermal deficiencies) associated with the first elongated member, such as due to the high loading level of the phase change material. Moreover, the second elongated member may comprise a polymer (or mixture of polymers) selected to improve the fiber's overall physical properties (e.g., mechanical properties) and the fiber's processability (e.g., by facilitating its formation via a melt spinning process). By surrounding the first elongated member, the second elongated member may serve to enclose the phase change material dispersed within the first elongated member to prevent loss or leakage of the phase change material.

Multi-component fibers in accordance with the invention can have virtually any proportion of the fiber's total weight comprising a first elongated member (or a first plurality of elongated members) having a temperature regulating material dispersed therein relative to a second elongated member (or a second plurality of elongated members). By way of example and not by limitation, when a thermal regulating property of a multi-component fiber is a controlling consideration, a larger proportion of the multi-component fiber may comprise a first elongated member having a temperature regulating material dispersed therein. On the other hand, when the physical properties of the multi-component fiber (e.g., mechanical properties) are a controlling consideration, a larger proportion of the multi-component fiber may comprise a second elongated member that does not have the temperature regulating material dispersed therein. Alternatively, when balancing thermal regulating and physical properties of the multi-component fiber, it may be desirable that the second elongated member has the same or a different temperature regulating material dispersed therein.

A multi-component fiber in accordance with some embodiments of the invention may comprise from about 1 percent up to about 99 percent by weight of a first elongated member (or a first plurality of elongated members). Typically, a multi-component fiber according to an embodiment of the invention may comprise from about 10 percent to about 90 percent by weight of a first elongated member (or a first plurality of elongated members). For instance, an embodiment of a core/sheath fiber comprises 90 percent by weight of a core member and 10 percent by weight of a sheath member. For this embodiment, the core member may comprise 60 percent by weight of a temperature regulating material, yielding a core/sheath fiber comprising 54 percent by weight of the temperature regulating material.

Multi-component fibers in accordance with various embodiments of the invention may be manufactured using a variety methods, such as, for example, using a melt spinning process. Multi-component fibers in accordance with some embodiments of the invention may be formed using a multi-component fiber spin line. Exemplary spin lines are described in Hills, U.S. Patent 5,162,074, entitled "Method of Making Plural Component Fibers" and references cited therein. For instance, a blend comprising a molten first polymeric material and a temperature regulating material dispersed therein and a molten second polymeric material may be provided. The blend and the molten second polymeric material may be directed to a spinneret comprising a plurality of orifices. More particularly, the blend and the molten second polymeric material may be directed to each orifice in various configurations to form a first elongated member (or a first plurality of elongated members) and a second elongated member (or a second plurality of elongated members), respectively, thus forming a multi-component fiber according to an embodiment of the invention. According to some embodiments of the invention, multi-component fibers may be formed using pellets comprising a first polymeric material and a temperature regulating material. According some embodiments of the invention, the pellets may comprise a solidified melt mixture of the temperature regulating material, a low molecular weight polymer, and a high molecular weight polymer. The pellets may be melted to form a blend and processed along with a molten second polymeric material as discussed above to form multi-component fibers.

### COMPARATIVE EXAMPLE

The following comparative example provides specific methodology useful in understanding and practicing the invention.

### Comparative Example 1

About five pounds of a low molecular weight polyethylene homopolymer (AC-16 polyethylene, drop point 102°C, manufactured by Honeywell Specialty Chemical) was added to a wet flushing apparatus, and the homopolymer was slowly melted and mixed at about 110° to about 130°C. Once the homopolymer was melted, about eight pounds of a wet cake was slowly added to the molten homopolymer over about a 30 minute time period to form a first blend. The wet cake comprised water-wetted microcapsules containing a phase change material (micro PCM lot #M 45-22, 63.2 percent by weight of microcapsules and phase change material, manufactured by Microtek Laboratories, Inc.).

Water was flashed off as the microcapsules containing the phase change material was added to and dispersed in the molten homopolymer. Mixing continued until less than about 0.15 percent by weight of the water remained (as measured using Karl-Fischer titration). The resulting first blend was then cooled and chopped to form a chopped material for further processing.

A dry blend was then formed by dry blending about thirty pounds of the chopped material with about seventy pounds of a fiber-grade polypropylene thermoplastic polymer (Polypropylene homopolymer 6852 from BP Amoco Polymers).

The resulting dry blend was then extruded using a 2 ½ inch single screw extruder with all zones set at about 230°C, with a screw speed of about 70 rpm, with 150 mesh filter screens, and with a nitrogen purge. In this manner, pellets were formed. The pellets were then dried overnight in a desiccant bed polymer pellet drying system at 105°C and at -40°C dewpoint. These pellets provided 23.1 J/g of thermal energy storage capacity (i.e., latent heat) as measured by DSC (Differential Scanning Calorimeter) measurements.

Multi-component fibers (here, bi-component fibers) were then melt spun on a bi-component fiber spin line using the pellets to from core members and using polypropylene or nylon to form sheath members. Spin lines of this general type are described in Hills, U.S. Patent 5,162,074, entitled "Method of Making Plural Component Fibers". The multi-component fibers were melt spun at temperatures between 230°C and 245°C.

Multi-component fibers with various core/sheath ratios and polymeric materials were produced. With reference to FIG. 4, a number of properties and manufacturing parameters of six core/sheath fibers that were produced are set forth. These fibers all incorporate a phase change material and microcapsules that contains the phase change material ("mPCM"), which makes up about 15 percent by weight of each fiber's core member and from about 7.5 percent to about 11.25 percent by weight of each fiber's total weight. Samples 1, 2 and 3 have a sheath member comprising polypropylene ("PP"), which is a polypropylene homopolymer from BP Amoco Polymers. Samples 4, 5 and 6 have a sheath member comprising Nylon 6, which is produced under the name Ultramid B from BASF Corp.

## Claims

1. A multi-component fiber having enhanced reversible thermal properties, comprising:
a first elongated member comprising a first polymeric material and a phase change material dispersed within the first polymeric material; and
a second elongated member comprising a second polymeric material, wherein the second elongated member is joined with the first elongated member;
**characterised in that** the phase change material is selected from the group consisting of solid/solid phase change materials and polymers.

2. The multi-component fiber of claim 1, wherein the phase change material is a polyhydric alcohol or a mixture of polyhydric alcohols.

3. The multi-component fiber of claim 2, wherein the phase change material is selected from the group consisting of polyethylene glycol, polypropylene, polypropylene glycol, polytetramethylene glycol, polyacrylate with alkyl hydrocarbon side chain, polyacrylate with polyethylene glycol side chain, poly(meth)acrylate with alkyl hydrocarbon side chain, poly(meth)acrylate with polyethylene glycol side chain, and mixtures thereof.

4. The multi-component fiber of claim 1, wherein the first polymeric material has an affinity for the phase change material to facilitate dispersing the phase change material within the first polymeric material.

5. The multi-component fiber of claim 1, wherein the first polymeric material and the second polymeric material are independently selected from the group consisting of polyamides, polyamines, polyimides, polyacrylics, polycarbonates, polydienes, polyepoxides, polyesters, polyethers, polyflourocarbons, formaldehyde polymers, natural polymers, polyolefins, polyphenylenes, silicon containing polymers, polyurethanes, polyvinyls, polyacetals, polyarylates, copolymers, and mixtures thereof.

6. The multi-component fiber of claim 1, wherein the first elongated member is surrounded by the second elongated member.

7. The multi-component fiber of claim 6, wherein the first elongated member is positioned within and completely surrounded by the second elongated member.

8. The multi-component fiber of claim 1, wherein the first elongated member comprises from about 10 percent to about 90 percent of a total weight of the multi-component fiber.

## Patentansprüche

1. Mehrkomponentenfaser mit reversiblen thermischen Eigenschaften, umfassend:
ein erstes längliches Element, das ein erstes Polymermaterial und ein im ersten Polymermaterial dispergiertes Phasenübergangsmaterial umfasst; und
ein zweites längliches Element, das ein zweites Polymermaterial umfasst, wobei das zweite längliche Element mit dem ersten länglichen Element verbunden ist;
**dadurch gekennzeichnet, dass** das Phasenübergangsmaterial aus der aus Fest/Fest-Phasenübergangsmaterialien und Polymeren bestehenden Gruppe ausgewählt ist.

2. Mehrkomponentenfaser nach Anspruch 1, worin das Phasenübergangsmaterial ein mehrwertiger Alkohol oder ein Gemisch aus mehrwertigen Alkoholen ist.

3. Mehrkomponentenfaser nach Anspruch 2, worin das Phasenübergangsmaterial aus der aus Polyethylenglykol, Polypropylen, Polypropylenglykol, Polytetramethylenglykol, Polyacrylat mit Alkylkohlenwasserstoff-Seitenkette, Polyacrylat mit Polyethylenglykol-Seitenkette, Poly(meth)acrylat mit Alkylkohlenwasserstoff-Seitenkette, Poly(meth)acrylat mit Polyethylenglykol-Seitenkette und Gemischen daraus bestehenden Gruppe ausgewählt ist.

4. Mehrkomponentenfaser nach Anspruch 1, worin das erste Polymermaterial eine Affinität für das Phasenübergangsmaterial aufweist, um die Dispergierung des Phasenübergangsmaterials im ersten Polymermaterial zu erleichtern.

5. Mehrkomponentenfaser nach Anspruch 1, worin das erste Polymermaterial und das zweite Polymermaterial unabhängig voneinander aus der aus Polyamiden, Polyaminen, Polyimiden, Polyacrylen, Polycarbonaten, Polydienen, Polyepoxiden, Polyestern, Polyethern, Polyfluorkohlenstoffen, Formaldehydpolymeren, natürlichen Polymeren, Polyolefinen, Polyphenylenen, siliciumhältigen Polymeren, Polyurethanen, Polyvinylen, Polyacetalen, Polyarylaten, Copolymeren und Gemischen daraus bestehenden Gruppe ausgewählt sind.

6. Mehrkomponentenfaser nach Anspruch 1, worin das erste längliche Element vom zweiten länglichen Element umgeben ist.

7. Mehrkomponentenfaser nach Anspruch 6, worin das erste längliche Element innerhalb des zweiten länglichen Elements angeordnet und vollständig davon umgeben ist.

8. Mehrkomponentenfaser nach Anspruch 1, worin das erste längliche Element etwa 10 % bis etwa 90 % des Gesamtgewichts der Mehrkomponentenfaser ausmacht.

## Revendications

1. Fibre multi -composant ayant des propriétés thermiques réversibles améliorées comprenant:
un premier élément allongé comprenant un premier matériau polymérique et un matériau de changement de phase dispersé dans le premier matériau polymérique; et
un second élément allongé comprenant un second matériau polymérique, où le second élément allongé est joint au premier élément allongé;
**caractérisées en ce que** le matériau de changement de phase est sélectionné dans le groupe consistant en matériaux de changement de phase solide/solide et polymères.

2. Fibre multi-composant de la revendication 1 où le matériau de changement de phase est un alcool polyhydrique ou un mélange d'alcools polyhydriques.

3. Fibre multi-composant de la revendication 2 où le matériau de changement de phase est sélectionné dans le groupe consistant en polyéthylène glycol, polypropylène, polypropylène glycol, polytétraméthylène glycol, polyacrylate avec une chaîne latérale d'hydrocarbure alkylique, polyacrylate avec une chaîne latérale de polyéthylène glycol, poly(méth)acrylate avec une chaîne latérale d'hydrocarbure d'alkyle, poly(méth)acrylate avec une chaîne latérale de polyéthylène glycol et leurs mélanges.

4. Fibre multi-composant de la revendication 1, où le premier matériau polymérique a une affinité pour le matériau de changement de phase pour faciliter la dispersion du matériau de changement de phase dans le premier matériau polymérique.

5. Fibre multi-composant de la revendication 1, où le premier matériau polymérique et le second matériau polymérique sont indépendamment sélectionnés dans le groupe consistant en polyamides, polyamines, polyimides, polyacryliques, polycarbonates, polydiènes, polyépoxydes, polyesters, polyéthers, polyfluorocarbones, polymères de formaldéhyde, polymères naturels, polyoléfines, polyphénylènes, polymères contenant du silicium, polyuréthane, polyvinyles, polyacétals, polyarylates, copolymères, et leurs mélanges.

6. Fibre multi-composant de la revendication 1, où le premier élément allongé est entouré du second élément allongé.

7. Fibre multi-composant de la revendication 6, où le premier élément allongé est positionné dans et complètement entouré par le second élément allongé.

8. Fibre multi-composant de la revendication 1, où le premier élément allongé forme environ 10 pour cent à environ 90 pour cent d'un poids total de la fibre multi - composant.
